# EUROPÄISCHE PATENTANMELDUNG

(11) **EP 3 926 675 A1**
(43) Veröffentlichungstag der Anmeldung: **22.12.2021**
(21) Anmeldenummer: 20181115.5
(22) Anmeldetag: 19.06.2020
(51) Int. Cl.: H01L 23/49, H01L 21/60, H01R 4/02, H01R 43/02

(54) **TEMPERATURSTABILER VERBUND EINER LITZE MIT EINEM AGPT-PAD**

(71) Anmelder: Heraeus Nexensos GmbH, 63801 Kleinostheim (DE)
(72) Erfinder: Muziol, Matthias, 63801 Kleinostheim (DE); Bleifuß, Martin, 63801 Kleinostheim (DE)
(74) Vertreter: Heraeus IP

(57) **Zusammenfassung**

Die Erfindung betrifft ein Elektroelement aufweisend mindestens einen Funktionsbereich und eine Kontaktfläche (120), wobei auf der Kontaktfläche ein Verbindungselement (180) angeordnet ist, wobei das Verbindungselement (180) eine mit Sintermaterial (182) beschichtete Litze umfasst, wobei die Litze durch ein Sintermaterial (182) mit der Kontaktfläche (120) verbunden, insbesondere versintert, ist. Weiterhin betrifft die Erfindung ein Verfahren zur Herstellung des erfindungsgemäßen Elektroelements.

## Beschreibung

Die vorliegende Erfindung betrifft ein Elektroelement auf dessen Kontaktfläche ein Verbindungselement angeordnet ist, wobei das Verbindungselement eine mit Sintermaterial beschichtete Litze umfasst. Weiterhin betrifft die Erfindung ein Verfahren zur Herstellung eines Verbindungselements.

In der elektrischen und elektronischen Verbindungstechnik sind Verbindungen, bei denen Drähte auf Bond Pads befestigt werden üblich. Bekannte Vorteile sind die bewährte Technik, ein hoher Leitungsquerschnitt und die günstigen Herstellkosten. Üblicher Weise werden Drähte auf Bond Pads mittels Lötens befestigt. Die dabei verwendeten Lötlegierungen haben meist einen Schmelzpunkt von unter 250°C und sind somit nicht für Anwendungen geeignet, die Temperaturen von 300°C erfordern.

Ein Nachteil der Verbindung von Drähten auf Bond Pads mittels Lötens ist die mangelnde mechanisch Stabilität gegen Vibrationen, da sie meist zu starr sind.

Im Stand der Technik wird dies gelöst durch die Verwendung einer Litze in Form eines Flachbandes anstatt eines Drahts. Litzen, z.B. in Form eines geflochtenen Flachbandes sind flexibler als Drähte und können Vibrationen besser abfedern. DE102009020733A1 beschreibt ein Flachband mit einer Dicke von 100 µm und eine Breite von 3 mm, das mittels Sintertechnik auf einem Bond Pad angebracht wird. Durch die Verwendung von Sinterpaste kann eine höhere Temperaturstabilität erreicht werden.

Die Verwendung von Litzen in Form eines Flachbandes hat allerdings Nachteile. Um einen ausreichend hohen Leitungsquerschnitt zu erreichen wird ein Flachband benötig, das eine hohe Kontaktfläche zu einem Kontaktpad aufweist. Dadurch ist es ungeeignet für Anwendungen, bei denen sehr kleine und eng nebeneinander liegende Kontaktpads elektrisch und mechanisch kontaktiert werden sollen.

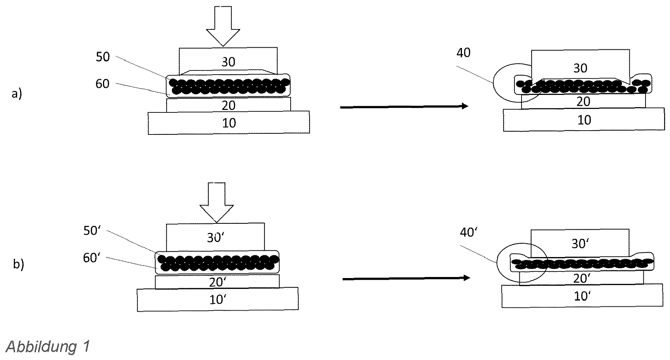

Das Flachband im Stand der Technik wird mittels Drucksintern mit einem Kontaktpad verbunden. Zum Drucksintern kommt ein beheizter Stempel mit ebener Druckfläche zum Einsatz (Abbildung 1 b)).

Alternativ wird ein beheizter Stempel verwendet, der am Rand eine Überhöhung aufweist und der eine kleinere Druckfläche aufweist als das zu kontaktierende Band. Dadurch wird beim Drucksintern durch den überhöhten Randbereich lokal ein höherer Druck erzeugt. Dies ist beispielhaft in Abbildung 1 a) dargestellt.

Nachteil eines Stempels mit ebener Druckfläche oder einer Druckfläche mit Überhöhungen im Randbereich ist, dass durch das Drucksintern die Litze weiter auseinander gequetscht wird. Durch das Auseinanderquetschen wird die Litze auf der Kontaktfläche noch breiter und kann sogar über die Fläche der Kontaktfläche hinaus gedrückt werden. Die gequetschten Randbereiche 40, 40' sind in Abbildung 1 schematisch dargestellt.

Aufgabe der vorliegenden Erfindung war es, ein verbessertes Verbindungselement für ein Elektroelement bereitzustellen, das auf einer möglichst kleinen Kontaktfläche mechanisch und thermisch stabil angebracht werden kann.

Insbesondere war es eine Aufgabe ein Verbindungselement bereitzustellen, das eine mit dem Verbindungselement zu verbindende Kontaktfläche möglichst vollständig bedeckt. Insbesondere sollte die Bedeckung der Kontaktfläche mit dem Verbindungselement mindestens 80% betragen.

Insbesondere war es eine Aufgabe der Erfindung ein Verbindungselement bereitzustellen, dass bei Temperaturen von mindestens 250°C, insbesondere bei mindestens 300°C mechanisch stabil ist.

Eine weitere Aufgabe der Erfindung bestand darin, Verfahren bereitzustellen, mit dem eine Litze möglichst platzsparend mit einer Kontaktfläche verbunden werden kann, ohne dabei den Leitungsquerschnitt der Litze herabzusetzten.

Mindestens eine Aufgabe wird gelöst durch die Gegenstände der kategoriebildenden Ansprüche.

In einem ersten Aspekt betrifft die Erfindung ein Elektroelement aufweisend mindestens einen Funktionsbereich und eine Kontaktfläche, wobei auf der Kontaktfläche ein Verbindungselement angeordnet ist, wobei das Verbindungselement eine mit Sintermaterial beschichtete Litze umfasst, wobei die Litze durch ein Sintermaterial mit der Kontaktfläche verbunden, insbesondere versintert, ist, dadurch gekennzeichnet, dass das Aspektverhältnis des Verbindungselements von Höhe (h) zu Breite (b) im Bereich von 0,5 - 3 liegt.

Durch die Erfindung kann erstmals ein Verbindungselement auf kleiner Kontaktflächen bei gleichzeitig hoher Leitungsquerschnitt bereitgestellt werden.

Die Litze ermöglicht eine flexible Anbindung mit hoher mechanischer Stabilität gegen Vibrationen. Das Sintermaterial des Verbindungselements bewirkt eine hohe Temperaturstabilität.

Das erfindungsgemäße Elektroelement kann ein Elektrikbauteil oder ein Elektronikbauteil sein. Elektrikbauteile sind bevorzugt dazu ausgebildet, Energie in Form von Elektrizität zu transportieren, zu steuern oder zu verändern. Elektronikbauteile sind bevorzugt dazu ausgebildet, Informationen in Form von Elektrizität zu transportieren, zu steuern oder zu verändern. Beispiele für Elektronikbauteile sind Halbleiterchips.

Das Elektroelement weist erfindungsgemäß einen Funktionsbereich und eine Kontaktfläche auf. Bevorzugt befindet sich das Elektroelement auf der Oberfläche eines Substrats, insbesondere eines isolierenden Substrats. Das isolierende Substrat kann plattenförmig ausgebildet sein. Das Material des isolierenden Substrats kann ausgewählt sein aus Keramiken, wie zum Beispiel Aluminiumoxid-Keramiken.

Der Funktionsbereich des Elektroelements ist erfindungsgemäß nicht weiter beschränkt. Der Funktionsbereich kann ausgewählt sein aus Halbleiterbauelementen, Elektronikbauteilen, Multisensorplattformen, Widerständen, Kondensatoren, Sensoren, LEDs oder Heizern.

Der Sensor kann beispielsweise eine Widerstandsstruktur sein. Die Widerstandsstruktur kann vorzugsweise mäanderförmig, gewickelt, gezackt oder als ineinandergreifende Fingerstrukturen ausgebildet sein.

Die Widerstandsstruktur kann ein Edelmetall aufweisen oder daraus bestehen. Das Edelmetall kann ausgewählt sein aus der Gruppe bestehend aus Gold, Silber, Platin, Palladium und Iridium.

Die Widerstandsstruktur kann auf einem Substrat mittels Dünnschicht-Techniken, z.B. mittels PVD (physical vapor deposition) aufgebracht werden. Die Höhe der Widerstandsstruktur auf dem Substrat kann bevorzugt im Bereich von 0,1 mm - 1 mm liegen, insbesondere im Bereich von 0,25 mm - 0,75 mm.

Weiterhin weist das Elektroelement eine Kontaktfläche auf. Die Kontaktfläche kann sich auf einem Abschnitt des Funktionsbereichs befinden oder getrennt vom Funktionsbereich auf einem vom Funktionsbereich verschiedenen Kontaktbereich des Elektroelements vorliegen. Der Kontaktbereich kann ein Kontaktpad, z.B. ein Bond Pad, sein.

Die Kontaktfläche weist bevorzugt ein sinterbares Material auf oder besteht daraus. Das sinterbare Material kann Metall enthalten oder daraus bestehen. Das Metall kann vorzugsweise ausgewählt sein aus der Gruppe bestehend aus Edelmetallen oder NichtEdelmetallen.

Edelmetalle können ausgewählt sein aus der Gruppe bestehend aus Gold, Silber, Platin, Palladium oder Iridium.

Nicht-Edelmetalle können ausgewählt sein aus der Gruppe bestehend aus Kupfer oder Nickel.

Das Metall kann ein elementares Metall oder eine Legierung aufweisen oder daraus bestehen.

In eine bevorzugten Ausführungsform ist das Metall eine Legierung. Die Legierung kann ein Edelmetall enthalten, das ausgewählt ist aus der Gruppe bestehend aus Gold, Silber, Platin, Palladium oder Iridium. Bevorzugt enthält die Legierung zwei oder mehr Edelmetalle. Beispielsweise kann die Legierung eine Silberlegierung oder eine Silber-Platinlegierung sein. In einer andere Ausführungsform kann die Legierung mindestens ein Edelmetall und mindestens ein Nicht-Edelmetall aufweisen. Optional kann die Legierung sowohl Edelmetall als auch Nicht-Edelmetall aufweise. Weiterhin ist es möglich, dass die Legierung Nichtmetalle umfasst.

Die Fläche der Kontaktfläche ist erfindungsgemäß nicht weiter beschränkt. In einer bevorzugten Ausführung weist die Kontaktfläche in eine erste Richtung eine Dimension von nicht mehr als 10 mm insbesondere nicht mehr als 2 mm und ganz besonders bevorzugt nicht mehr als 0,5 mm auf.

In einer andere Ausführungsform weist die Kontaktfläche in einer zur ersten Richtung senkrechten zweiten Richtung eine Dimension von nicht mehr als 30 mm oder nicht mehr als 10 mm, insbesondere nicht mehr als 5 mm und ganz besonders bevorzugt nicht mehr als 1,5 mm auf.

Die Form der Kontaktfläche ist nicht weiter beschränkt. Beispielsweise kann die Kontaktfläche rund oder eckig sein, insbesondere rechteckig.

In einer möglichen Ausführung ist die Kontaktfläche eben oder gewölbt. Eine gewölbte Kontaktfläche weist eine dreidimensionale Struktur auf.

Erfindungsgemäß ist auf der Kontaktfläche ein Verbindungselement angeordnet. Das Verbindungselement ist bevorzugt mit der Kontaktfläche versintert.

Sintermaterialien werden bevorzugt aus einzelnen Partikeln hergestellt, die auf eine Temperatur unterhalb ihrer Schmelztemperatur erhitzt werden. Während des Sintervorgangs kommt es bevorzugt zur Diffusion von Atomen oder Molekülen des Partikels, hin zu den Kontaktpunkten von benachbarten Partikeln. An den Kontaktpunkten kommt es so beim Sintern zur Ausbildung einer stoffschlüssigen Verbindung. Werden Metalle gesintert kann durch Ausbildung von metallischen Verbindungen zwischen einzelnen Partikeln die elektrische Leitfähigkeit des Partikelverbundes erhöht werden. Da die Partikel auf eine Temperatur unterhalb der Schmelztemperatur erhitzt werden bleibt die Partikelmorphologie, z.B. Form oder Größe, zumindest teilweise erhalten.

Bevorzugt bedeckt das Verbindungselement, insbesondere das mit der Kontaktfläche versinterte Verbindungselement, die Kontaktfläche zu mindestens 50% oder mindestens 60 oder mindestens 70 % oder mindestens 80 %. Insbesondere bedeckt das Verbindungselement die Kontaktfläche zu mindestens 90 % oder ganz besonders bevorzugt zu 100%.

In einer möglichen Ausführungsform bedeckt das Verbindungselement die Kontaktfläche vollständig und ragt zu höchstens 10 % oder zu höchstens 30 % über die Kontaktfläche hinaus.

Erfindungsgemäß umfasst das Verbindungselement eine mit Sintermaterial beschichtete Litze. Eine Litze weist mehrere Einzeldrähte auf. Insbesondere weist die Litze ein Bündel von Einzeldrähten auf. Bevorzugt weist die Litze mindestens fünf Einzeldrähte auf. Weiterhin weist die Litze bevorzugt höchstens 50, insbesondere höchstens 30 und ganz besonders bevorzugt höchstens 20 Einzeldrähte auf. Besonders bevorzugt weist die Litze 7 - 19 Einzeldrähte auf, insbesondere besteht die Litze aus 7 oder 19 Einzeldrähten.

Die bündelförmig zusammengefassten Einzeldrähte können beispielsweise miteinander verdreht, verseilt oder verflochten sein. Besonders bevorzugt sind verseilte Litzen.

Der Durchmesser der Einzeldrähte kann bevorzugt im Bereich von 0,1 mm bis 0,3 mm liegen.

In einer Ausführungsform der Erfindung weisen die Einzeldrähte ein Metall auf. Insbesondere kann das Metall der Einzeldrähte ein elementares Metall oder eine Metalllegierung sein. Das Metall kann ausgewählt sein aus Elementen der Gruppe bestehend aus Gold, Platin, Silber, Kupfer, Aluminium oder Nickel oder einer Kombination von mindestens zwei dieser Elemente. Insbesondere weisen die Einzeldrähte ein Nichtedelmetall auf oder bestehen daraus. Besonders bevorzugt ist das Metall der Einzeldrähte Kupfer.

In einer möglichen Ausführungsform sind die Einzeldrähte der Litze beschichtet, z.B. mit Silber. Die Beschichtung der Einzeldrähte geschieht bevor die Litze aus den Einzeldrähten hergestellt wird. Die Beschichtung der Litze kann durch galvanische Verfahren erfolgen. Die Beschichtung der Einzeldrähte weist bevorzugt eine Dicke im Bereich von 0,2 - 2 µm auf, insbesondere im Bereich von 0,5 - 2 µm.

Das Sintermaterial enthält bevorzugt eine Vielzahl von miteinander versinterten Pulverpartikeln, die jeweils mit benachbarten Partikeln versintert sind. Im Gegensatz zu geschmolzenen oder gelöteten Materialien werden beim Sintern die Partikel bevorzugt nicht oder nur zum Teil geschmolzen.

Bevorzugt ist im Sintermaterial die Partikelmorphologie der einzelnen Partikel erhalten geblieben und kann mit Methoden, die dem Fachmann für Pulvermetallurgie bekannt sind, auf analytischem Wege bestimmt werden. Beispielsweise können die versinterten Partikel mit geeigneten mikroskopischen Verfahren wie Lichtmikroskopie oder Elektronenmikroskopie bestimmt werden

Das Sintermaterial kann die Litze vollständig umgeben. Bevorzugt liegt das Sintermaterial nicht nur auf der Oberfläche der Litze, also dem Bündel von Einzeldrähten, vor sondern umgibt zumindest teilweise die Einzeldrähte der Litze. Das Sintermaterial enthaltend versinterte Partikel ist bevorzugt auch mit dem Material der Einzeldrähte versintert.

Weiterhin weist das Sintermaterial möglichst auch eine Sinterverbindung mit der Kontaktfläche auf.

In einer besonders bevorzugten Ausführungsform der Erfindung ist das Sintermaterial des Verbindungselements annähernd homogen versintert und weist keine Bereiche auf, die besonders wenig oder besonders stark versintert sind. In diesem Zusammenhang wird auf Abbildung 1 verwiesen, die den Stand der Technik wiedergibt. In Abbildung 1 a) wird ein Stempel mit Randüberhöhung auf ein Flachband mit Sintermittel gepresst. Der Druck des Stempels ist im Bereich der Randüberhöhung hoch, sodass dort das Sintermittel besonders stark versintert und ein dichtes Sintermaterial bildet. Dagegen weist das Sintermaterial in den Bereichen, in denen das Flachband nicht durch die Randüberhöhung verpresst wurde, eine geringere Dichte auf. Demgegenüber ist das Sintermaterial der vorliegenden Erfindung über den Bereich des Verbindungselements im Wesentlichen homogen und weist eine imm wesentlichen konstante Dichte auf.

In einer besonders bevorzugten Ausführungsform sind die Einzeldrähte der Litze in dem Sintermaterial eingebettet und stehen über das Sintermaterial mit der Kontaktfläche in Kontakt.

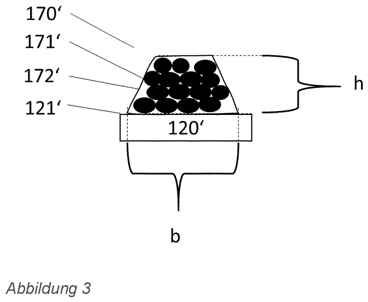

Das Verbindungselement aufweisend eine Litze und ein Sintermaterial, angeordnet auf der Kontaktfläche weist im Querschnitt - also senkrecht zur Hauptausdehnungsrichtung der Litze - ein Aspektverhältnis von 0,5 - 3 auf. Das Aspektverhältnis errechnet sich aus dem Verhältnis der Höhe (h) des Verbindungselementes zur Breite (b) des Verbindungselementes. Die Höhe (h) wird gemessen von der Oberfläche der Kontaktfläche bis zum höchsten Punkt des Verbindungselements. Die Breite (b) des Verbindungselements wird senkrecht zur Höhe (h) gemessen an der Grenzfläche zwischen Kontaktfläche und Verbindungselement. Dies ist beispielhaft in Abbildung 3 gezeigt. Die Höhe des Verbindungselements ist mit (h) bezeichnet und die Breite mit (b). Das Aspektverhältnis errechnet sich durch (h)/(b).

Ein hohes Aspektverhältnis ist vorteilhaft, da die Kontaktierung der Kontaktfläche durch das Verbindungselement wenig Platz benötigt. Bei sehr eng nebeneinander liegenden Kontaktflächen ist dies vorteilhaft, da Kurzschlüsse vermieden werden, ohne den Leitungsquerschnitt signifikant zu senken.

Vorzugsweise kann das Verbindungselement eine mechanische stabile Verbindung bis zu einer Temperatur von mindestens 300°C herstellen.

In einem weiteren Aspekt betrifft die Erfindung ein Verfahren zur Herstellung eines Verbindungselements auf einer Kontaktfläche aufweisend die Schritte:
a) Bereitstellen einer Litze, einer Kontaktfläche auf einem Elektroelement und eines Sintermittels,
b) Beschichten zumindest eines Teils der Litze mit Sintermittel unter Erhalt einer beschichteten Litze,
c) Positionieren der beschichteten Litze auf der Kontaktfläche,
d) Verbinden der beschichteten Litze mit der Kontaktfläche mittels Drucksintern unter Verwendung eines beheizten Stempels, unter Erzeugung eines Verbindungselements,
dadurch gekennzeichnet, dass der beheizte Stempel eine Vertiefung mit einer Öffnung aufweist wobei die Vertiefung im Stempel die beschichtete Litze beim Verbinden partiell aufnimmt und wobei die Öffnung der Vertiefung größer ist als der Durchmesser der beschichteten Litze, sodass die beschichtete Litze beim Drucksintern in die Vertiefung im Stempel auf die Kontaktfläche gepresst wird.

In Schritt a) wird erfindungsgemäß eine Litze bereitgestellt. Die Litze (engl. *stranded wire*) ist bevorzugt als ein Bündel aus mehreren Einzeldrähten zu verstehen. Die Einzeldrähte können dabei miteinander verseilt, verdreht oder verflochten sein. Besonders bevorzugt sind die Einzeldrähte der Litze miteinander verseilt. Bevorzugt ist das Bündel aus Einzeldrähten annähernd rund ausgebildet. Insbesondere liegt im Querschnitt der Litze das Verhältnis zwischen kürzestem Durchmesser zu längstem Durchmesser im Bereich von 0,5 bis 1,5 insbesondere im Bereich von 0,8 bis 1.

Die Litze, insbesondere die Gesamtheit der zum Bündel gefassten Einzeldrähte, weist im Querschnitt bevorzugt einen Durchmesser auf der im Bereich von 0,1 mm bis 2 mm, insbesondere im Bereich von 0,3 mm - 1,5 mm und ganz besonders bevorzugt im Bereich von 0,25 mm - 0,6 mm liegt.

In einer bevorzugten Ausführungsform weist die Litze einen Durchmesser auf, der nicht mehr als 20% von der Breite der Kontaktfläche abweicht.

Bevorzugt weist die Litze zumindest bereichsweise auf ihrer äußeren Oberfläche eine elektrische Isolierschicht auf. Beispielsweise ist die Litze zumindest teilweise von einer elektrischen Isolierschicht umhüllt. In einer möglichen Ausführung ist die Litze an einem Ende nicht mit elektrischer Isolierschicht umgeben. In diesem Fall liegen die Einzeldrähte der Litze frei und können elektrisch kontaktiert werden. Dies kann beispielsweise erreicht werden, indem eine Litze mit elektrischer Isolierschicht nachträglich abisoliert wird. Beispielsweise können die letzten 0,5 mm - 5 mm einer Litze frei von Isolierschicht sein. Das Material der Isolierschicht kann ausgewählt sein aus der Gruppe bestehend aus Kunststoffen wie beispielsweise Thermoplaste, Duroplaste, Elastomere oder Glasfaserwerkstoffe (z.B. Glasseide). Die Isolierschicht kann ein Isolierlack sein. In einer möglichen Ausführung der Erfindung weist die Isolierschicht Polyimid (Kapton^{™}) auf oder besteht daraus.

Alternativ ist es auch denkbar, dass die Litze eine Unterbrechung in einer im Wesentlichen durchgängigen Isolierschicht aufweist. Die Unterbrechung der Isolierschicht kann sich bevorzugt nicht am Ende der Litze befinden. An der Stelle der Unterbrechung der Isolierschicht sind die Einzeldrähte der Litze zugänglich und elektrisch kontaktierbar.

Des Weiteren wird eine Kontaktfläche auf einem Elektroelement bereitgestellt. Das Elektroelement weist bevorzugt einen Funktionsbereich auf, wie er in dieser Anmeldung beschrieben ist.

Weiterhin weist das Elektroelement eine Kontaktfläche auf. Die Kontaktfläche kann sich auf einem Abschnitt des Funktionsbereichs befinden oder getrennt vom Funktionsbereich, auf einem vom Funktionsbereich verschiedenen Kontaktbereich des Elektroelements, vorliegen. Der Kontaktbereich kann beispielsweise ein Kontaktpad sein.

Weiterhin wird in Schritt a) ein Sintermittel bereitgestellt. Bevorzugter Weise weist das Sintermittel ein sinterbares Metall auf, insbesondere ein Edelmetall. Besonders bevorzugt enthält das Sintermittel Silber.

Das Sintermittel kann beispielsweise eine Sinterpaste sein. Eine Sinterpaste enthält Metallpartikel. Die Metallpartikel können beispielsweise sphärische Partikel oder Flocken (engl. *flakes*) umfassen. Besonders bevorzugt enthält die Sinterpaste Silberflocken (Ag*flakes*).

Weiterhin enthält eine Sinterpaste organische Komponenten. Die organischen Komponenten können ausgewählt sein aus der Gruppe bestehend aus organischen Lösungsmitteln, Dispergiermitteln, Rheologievermittlern, Benetzungsmitteln oder beliebigen Kombinationen dieser Komponenten. Bevorzugt enthält die Sinterpaste mindestens ein organisches Lösungsmittel.
Bevorzugte organische Komponenten sind ausgewählt aus Terpineol und 2-Ethlyhexane- 1, 3-diol.

Optional kann die Sinterpaste weitere Partikel enthalten, die entweder sinterbar sind oder keine Sinterverbindung ausbilden können, insbesondere nicht bei den Bedingungen, bei denen die sinterbaren Metallpartikel versintern können.

In einer bevorzugten Ausführungsform enthält die Sinterpaste weniger als 10 Gew.-%, insbesondere weniger als 5 Gew.-% oder weniger als 1 Gew.-% Partikel, die keine metallbasierten Partikel, insbesondere keine Metallpartikel, sind.

In Schritt b) wird die Litze mit Sintermittel beschichtet unter Erhalt einer beschichteten Litze. Insbesondere wird die Litze mit Sinterpaste beschichtet.

In einer bevorzugten Ausgestaltung der Erfindung wird die Litze so mit Sinterpaste beschichtet, dass die Einzeldrähte der Litze zumindest teilweise oder vollständig von Sintermittel, insbesondere Sinterpaste umgeben sind. Anders ausgedrückt, wird die Litze in das Sintermittel getaucht oder damit getränkt. In einer möglichen Ausführung werden durch das Beschichten der Litze die Zwischenräume zwischen den Einzeldrähten mit Sintermittel gefüllt.

Das Beschichten der Litze mit Sintermittel erfolgt bevorzugt durch ein Tränken oder eine Tauchbeschichtung. Dazu kann beispielsweise ein Ende der Litze, das keine Isolierschicht aufweist, in eine Sinterpaste getaucht werden.

Optional kann die beschichtete Litze getrocknet werden, insbesondere, wenn das Sintermittel eine Sinterpaste ist. Das Trocknen kann bei einer Temperatur im Bereich von 20°C bis 200°C erfolgen.

Weiterhin wird die beschichtete Litze in Schritt c) auf der Kontaktfläche positioniert. Vorzugsweise wird die Litze so positioniert, dass diese nur die Kontaktfläche kontaktiert.

In Schritt d) erfolgt ein Verbinden der beschichteten Litze mit der Kontaktfläche mittels Drucksintern mit einem beheizten Stempel unter Erzeugung eines Verbindungselements.

Bei dem Drucksintern übt ein beheizter Stempel einen hohen Druck auf die beschichtete Litze aus, sodass das Sintermittel mit sich selbst versintert. Das bedeutet, dass bevorzugt die Pulverpartikel des Sintermittels sich miteinander verbinden und ein kontinuierliches Gefüge erzeugen. Durch Drucksintern wird das Sintermittel in ein Sintermaterial umgewandelt. Durch die erhöhte Temperatur werden vorhandene organische Bestandteile des Sintermittels, insbesondere der Sinterpaste, zumindest teilweise entfernt. Die organischen Bestandteile könne sich beim Drucksintern zu flüchtigen, gasförmigen Substanzen zersetzen oder verdampfen.

Die Temperatur des Drucksinterns ist erfindungsgemäß nicht weiter beschränkt und hängt von dem verwendeten Sintermittel ab. Die einzustellende Temperatur für das jeweilige Sintermittel ist dem Fachmann für elektrische Verbindungstechnik bekannt. Beispielsweise kann eine silberhaltige Sinterpaste bei einer Temperatur im Bereich von 300°C - 500°C gesintert werden.

Es erweist sich auch als vorteilhaft das Substrat, auf dem sich die Kontaktfläche befindet vor dem Drucksintern zu erhitzen, vorzugsweise auf eine Temperatur, die unter der Sintertemperatur liegt.

Der Druck, der beim Drucksintern durch den beheizten Stempel ausgeübt wird, ist erfindungsgemäß nicht beschränkt und hängt vom jeweils verwendeten Sintermittel ab. Der bevorzugte Druck zum Drucksintern liegt beispielsweise im Bereich von 20 N/mm² bis 60 N/mm².

Die Dauer des Drucksinterns kann im Bereich von 0,5 Sekunden bis 60 Sekunden liegen, bevorzugt im Bereich von 5 Sekunden bis 20 Sekunden.

Vorzugsweise versintert das Sintermittel in den beschichteten Bereichen mit der Litze, insbesondere mit mehreren oder allen Einzeldrähten der Litze.

Weiterhin bevorzugt bildet das Sintermittel auch mit der Kontaktfläche eine Sinterverbindung aus, wodurch ein Verbindungselement gemäß der vorliegenden Erfindung erzeugt wird.

In dem Verbindungselement sind die Einzeldrähte der Litze bevorzugt in einer Matrix aus Sintermaterial eingebettet und werden mechanisch fest auf der Kontaktfläche verankert. Weiterhin kann das gesinterte Verbindungselement eine hohe elektrische und/oder thermische Leitfähigkeit aufweisen.

Erfindungsgemäß weist der beheizte Stempel eine Vertiefung mit einer Öffnung auf. Die Vertiefung im Stempel ist derart ausgebildet, dass die beschichtete Litze beim Verbinden partiell in die Vertiefung aufgenommen werden kann. Dadurch, dass die beschichtete Litze während des Drucksinterns in der Vertiefung aufgenommen werden kann, kann die Position des zu erzeugenden Verbindungselements sehr genau bestimmt werden.

Die Öffnung der Vertiefung ist größer ist als der Durchmesser der beschichteten Litze, sodass die beschichtete Litze beim Drucksintern in die Vertiefung im Stempel und auf die Kontaktfläche gepresst wird. Da der Durchmesser der Vertiefung größer ist als der Durchmesser der beschichteten Litze, üben die Randbereiche um die Vertiefung herum keinen Druck auf die beschichtete Litze aus.

Dadurch, dass der Durchmesser der Öffnung der Vertiefung größer ist als der Durchmesser der Litze stellt die Vertiefung für die beschichtete Litze bevorzugt eine Begrenzung dar, sodass die beschichtete Litze nicht über die Kontaktfläche hinaus gepresst wird.

Durch die erfindungsgemäße Vertiefung mit den genannten Abmessungen kann die beschichtete Litze und das daraus resultierende Verbindungselement derart geformt werden, dass es ein Aspektverhältnis von Breite (b) zur Höhe (h) im Bereich von 0,5 - 3 aufweisen kann.

Bevorzugt wird die beschichtete Litze in die Vertiefung im beheizten Stempel gepresst und derart verformt, dass die Litze und das Sintermittel die Form der Vertiefung annehmen.

Die Vertiefung weist bevorzugt eine Tiefe (t) und eine Breite (w) auf. Die Tiefe (t) wird bestimmt durch den maximalen Abstand einer geraden Verbindungslinie zwischen den Randbereichen der Öffnung und dem tiefsten Punkt der Vertiefung. Die Breite (w) gibt den Abstand zwischen gegenüberliegenden Rändern der Öffnung an.

Die Form der Vertiefung ist erfindungsgemäß nicht weiter beschränkt. Bevorzugt weist die Vertiefung die Form einer Kerbe auf, die vorzugsweise die beschichtete Litze aufnehmen kann. Beispielsweise kann der Querschnitt der Vertiefung eine dreieckige, trapezartige, rechteckige oder runde Form aufweisen. In Abbildung ist beispielsweise ein trapezförmiger Querschnitt einer Vertiefung in einem Stempel dargestellt.

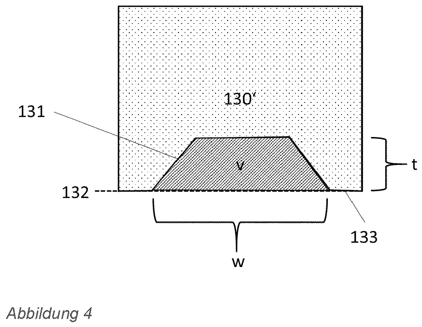

Die Größen (t) und (w) sind in Abbildung 4 exemplarisch dargestellt. Der schraffierte, mit (v) gekennzeichnete Bereich in Abbildung 4 zeigt das Volumen der Vertiefung an.

Das Aspektverhältnis von der Tiefe (t) zur Breite (w), (t)/(w), liegt bevorzugt im Bereich von 0,5 - 3, insbesondere im Bereich von 1 - 2.

Bevorzugt ist das Volumen (v) kleiner als das Volumen der beschichteten Litze, sodass der beheizte Stempel beim Drucksintern einen Druck auf die beschichtete Litze ausüben kann. Insbesondere ist das Volumen v der Vertiefung höchstens 10% kleiner, insbesondere höchstens 5% kleiner als das Volumen der beschichteten Litze.

Die Stempeloberfläche, die beim Drucksintern mit dem Sintermittel in Kontakt kommt, weist vorzugsweise eine Antihaftbeschichtung auf damit das Sintermittel nicht mit der Oberfläche des Stempels versintert. Beispielsweise kann die Stempeloberfläche aus einer mit einer Eisenschicht und zusätzlich einer Chrom/Nickelschicht beschichteten Kupferlegierung bestehen.

Optional kann das erhaltene Verbindungselement mit einem elektrisch isolierenden Material verkapselt werden. Dies kann vorteilhaft sein, um das Verbindungselement vor Umwelteinflüssen wie Sauerstoff oder Feuchtigkeit zu schützen und somit die Lebensdauer des Verbindungselements zu erhöhen.

In einer bevorzugten Weiterbildung der Erfindung kann ein beheizter Stempel mehrere Vertiefungen aufweisen. Dadurch kann der erfindungsgemäße Prozess parallelisiert werden, da mit einem Stempel mehrere Verbindungselemente gleichzeitig mittels Drucksintern hergestellt werden können. Dies kann insbesondere dann nützlich sein, wenn das zu verbindende Elektroelement mehrere Kontaktflächen aufweist, die jeweils über ein erfindungsgemäßes Verbindungselement verbunden werden sollen.

Weitere Merkmale und Vorteile der Erfindung ergeben sich aus der nachfolgenden Beschreibung, in der bevorzugte Ausführungsformen der Erfindung anhand von schematischen Zeichnungen erläutert sind.

Dabei zeigt:
Abbildung 1 eine Skizze des Verfahrens aus dem Stand der Technik, bei dem ein Flachbandkabel auf einem Kontaktpad befestigt wird;
Abbildung 2 eine schematische Darstellung des erfindungsgemäßen Verfahrens bei dem eine beschichtete Litze mit einem beheizten Stempel auf einem Kontaktpad befestigt wird;
Abbildung 3 einen Querschnitt einer Ausführungsform des erfindungsgemäßen Verbindungselements;
Abbildung 4 einen Querschnitt einer Ausführungsform eines erfindungsgemäß verwendeten Stempels.

Abbildung 1 illustriert den Stand der Technik. In Abbildung 1a) wird ein Litze 50 in Form eines Flachbands, die mit Sintermittel 60 beschichtet ist auf einem Kontaktpad 20 positioniert, wobei das Kontaktpad auf einem Substrat 10 angeordnet ist. Durch den beheizten Stempel 30 wird die beschichtete Litze mit dem Kontaktpad versintert. Der beheizte Stempel 30 weist eine Randüberhöhung auf. Der eingekreiste Bereich 40 stellt herausgequetschtes Sintermaterial und Litzendrähte dar.

In Abbildung 1b) wird eine Litze 50' in Form eines Flachbands, die mit Sintermittel 60' beschichtet ist auf einem Kontaktpad 20' positioniert, wobei das Kontaktpad auf einem Substrat 10' angeordnet ist. Durch den beheizten Stempel 30' wird die beschichtete Litze mit dem Kontaktpad versintert. Der beheizte Stempel 30' weist eine ebene Druckfläche. Der eingekreiste Bereich 40' stellt herausgequetschtes Sintermaterial und Litzendrähte dar.

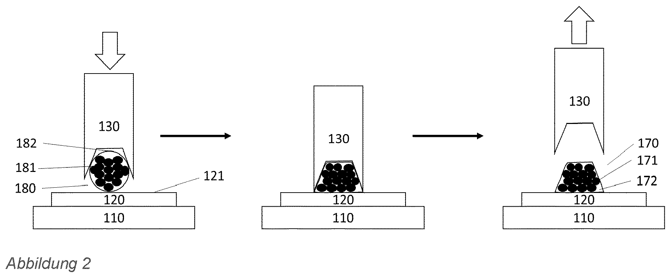

Abbildung 2 zeigt schematisch den beispielhaften Ablauf des erfindungsgemäßen Verfahrens. Zuerst wird eine beschichtete Litze 180 mit annähernd runder Form auf einer Kontaktfläche 121 eines Kontaktpads 120 positioniert. Das Kontaktpad 120 ist auf einem Substrat 110 befestigt. Die Litze umfasst eine Litze 181, die aus Einzeldrähten besteht. Die Litze ist mit Sintermittel 182 beschichtet. Mittels dem beheizten Stempel 130 wird auf die beschichtete Litze Druck ausgeübt. Dabei wird die beschichtete Litze 180 verformt und passt sich der Vertiefung im beheizten Stempel 130 an. Da die Öffnung der Vertiefung im beheizten Stempel 130 größer ist als der Durchmesser der beschichteten Litze 180, wird die beschichtete und verformte Litze durch die Vertiefung begrenzt. Der beheizte Stempel 130 übt solange Druck auf die Litze aus bis das Sintermittel 171 mit der Litze und der Kontaktfläche 121 versintert ist. Anschließend wird er beheizte Stempel 130 angehoben und somit das erhaltene Verbindungselement 170 freigelegt. Das Verbindungselement 170 weist eine Litze 171 und Sintermaterial 172 auf.

Abbildung 3 stellt einen Querschnitt eines erfindungsgemäßen Verbindungselements 170' auf einer Kontaktfläche 121' eines Kontaktpads 120' dar. Das Verbindungselement weist eine Breite (b) im Kontaktbereich mit der Kontaktfläche 121' auf. Weiterhin weist das Verbindungselement eine Höhe (h) auf, die von der Kontaktfläche 121' bis zum höchsten Punkt des Verbindungselements gemessen wird.

Abbildung 4 stellt einen beispielhaften beheizten Stempel 130' schematisch dar. Der beheizte Stempel weist eine imaginäre Ebene 132 auf, die durch die Randbereiche 133 der Öffnung läuft. Die Öffnung im beheizten Stempel 130' weist eine Breite (w) Entlang der imaginären Ebene 132 und zwischen den Randbereichen der 133 auf. Die Vertiefung 131 weist eine Tiefe (t) auf die von der imaginären Ebene 132 bis zum tiefsten Punkt der Vertiefung 131 reicht. Das Volumen (v) der Vertiefung 131 wird durch die imaginäre Ebene 132 begrenzt.

### Bezugszeichenliste

- 10, 10': Substrat
- 20, 20': Kontaktpad
- 30, 30': beheizter Stempel
- 40, 40': Randbereich nach dem Drucksintern
- 50, 50': Litze aus Einzeldrähten
- 60, 60': Sintermittel
- 110, 110': Substrat
- 120, 120': Kontaktpad
- 121, 121': Kontaktfläche
- 130, 130': beheizter Stempel
- 131: Vertiefung
- 132: imaginäre Ebene der Öffnung der Vertiefung laufend durch die Randbereiche 133
- 133: Randbereich der Vertiefung
- 170, 170': Verbindungselement
- 171, 171': Litze aus Einzeldrähten
- 172, 172': Sintermaterial
- 180: beschichtete Litze
- 181: Litze aus Einzeldrähten
- 182: Sintermittel
- b: Breite des Verbindungselements
- h: Höhe des Verbindungselements
- w: Breite der Öffnung der Vertiefung im beheizten Stempel
- t: Tiefe der Vertiefung

### Beispiele

### Ausführungsbeispiel 1:

Es wurde ein Pt-Temperaturwiderstand als Temperatursensor bereitgestellt, z.B. ein PT1000 mit der Bezeichnung SMD-FC 0805 (Heraeus Nexensos GmbH, Deutschland). Die Größe des Sensors betrug 2,1 mm x 1,35 mm (B x L). Der Temperaturwiderstand war auf einem Aluminiumoxid-Substrat aufgebracht.

Die Kontaktpads bestanden aus einer siebgedruckten Ag-Pt-Legierung und kontaktierten die Pt-Widerstandstruktur an ihren Enden. Die Kontaktfläche der Kontaktpads betrug 0,5 mm x 1,35 mm.

Als Zuleitung wurden zwei Litzen verwendet, die einen Durchmesser von 0,48 mm aufwiesen. Jede der beiden Litzen bestand aus 19 Kupfer-Einzeldrähten mit einem Durchmesser von jeweils 0,1 mm. Die Kupfer-Einzeldrähte waren mit einer dünnen Silberschicht beschichtet.

Die Litzen wiesen eine Isolierung aus PTFE auf. An jeweils einem Ende jeder Litze wurde die Isolierung durch Einschneiden und Abziehen entfernt, um einen ca. 1,5 mm langen Kontaktbereich zu erzeugen.

Die freien Enden der Litze wurden in eine Sinterpaste (HERAEUS ASP 295-09P9) getaucht und dann jeweils mittig auf den beiden Kontaktpads positioniert. Der Temperatursensor wies dabei eine Temperatur von ca. 250°C auf. Der Temperatursensor lag dabei auf einem von unten geheizten Halter. Der Stempel zum Drucksintern der mit Sinterpaste getränkten Litzenenden mit dem Kontaktpad hatte eine rechteckige Stempelfläche, die der Temperatursensoroberfläche angepasst war und ca. eine Größe von 2 mm x 3 mm (B x L) aufwies. In der Stempelfläche befanden sich zwei Längskerben, die parallel verliefen. Die Längskerben wiesen einen trapezförmigen Querschnitt auf. Die Tiefe der Längskerbe betrug 0,3 mm und die Breite der Öffnung betrug 0,5 mm.

Während die Sinterpaste trocknete, wurde der auf 350°C geheizte Stempel abgesenkt und mit einem Druck von ca. 40 N/mm² auf die beiden mit Sinterpaste getränkten Litzenenden gepresst. Die Litzenenden verformten sich entsprechend der durch die Längskerben vorgegebene Struktur. Der Druck wurde ca. 10 Sekunden auf die Sinterpaste mit der Litze ausgeübt. Anschließend wurde der Stempel von dem erzeugten Verbindungselement abgehoben. Die Stempeloberfläche, die aus oxidierter Kupferlegierung bestand, war auch nach wiederholtem Einsatz frei von Rückständen aus der Sinterpaste.

In einem Zugversuch, bei dem der Temperatursensor fixiert wurde, wurde in der Hauptachse der Litze, also parallel zur Sensoroberfläche mit einem Zugtester eine ansteigende Zugkraft angelegt. Die Zugfestigkeit der Verbindung wurde in dem Moment bestimmt, bei dem sich die Verbindung löste. Die ermittelte Zugfestigkeit betrug 30 N.

In einem Dauerlagerungsversuch wurde ein Temperatursensor mit erfindungsgemäßem Verbindungselement für 140 Stunden bei einer Temperatur von 250°C ausgelagert. Die Verbindungen hatten sich nach Abschluss der Temperaturbehandlung nicht gelöst.

In einem Wechseltest wurde ein Temperatursensor mit erfindungsgemäßem Verbindungselement 40-mal von 250°C auf 22°C abgekühlt. Die Verbindungen hatten sich nicht gelöst.

### Vergleichsbeispiel:

Abweichend vom Ausführungsbeispiel 1 wurde ein Stempel mit flacher Oberfläche, d.h. mit einer ebenen Stempeloberfläche, zum Drucksintern des Verbindungselements verwendet. Die Litzenenden wurden flach gedrückt und spleißten dabei auf, sodass die Einzeldrähte weit über das Kontaktpad hinausragten.

## Patentansprüche

1. Elektroelement aufweisend mindestens einen Funktionsbereich und eine Kontaktfläche, wobei auf der Kontaktfläche ein Verbindungselement angeordnet ist, wobei das Verbindungselement eine mit Sintermaterial beschichtete Litze umfasst, wobei die Litze durch ein Sintermaterial mit der Kontaktfläche verbunden, insbesondere versintert, ist, **dadurch gekennzeichnet, dass** das Aspektverhältnis des Verbindungselements von Höhe (h) zu Breite (b) im Bereich von 0,5 - 3 liegt.

2. Elektroelement gemäß Anspruch 1, wobei das Elektroelement ein elektrisches oder elektronisches Bauteil ist, bevorzugt ein Sensor.

3. Elektroelement gemäß einem der Ansprüche 1 oder 2 wobei das Sintermaterial ein Edelmetall, insbesondere Silber, aufweist oder daraus besteht.

4. Elektroelement gemäß einem der Ansprüche 1 - 3, wobei die Litze außerhalb des Verbindungselements zumindest teilweise von einer Isolationsschicht umgeben ist.

5. Elektroelement gemäß einem der Ansprüche 1 - 4, wobei die Litze mehrere Einzeldrähte enthält und wobei die Einzeldrähte jeweils zumindest teilweise mit Sintermaterial beschichtet sind.

6. Elektroelement gemäß einem der Ansprüche 1 - 5, wobei die Litze mehrere Einzeldrähte enthält, die ein Material aufweisen, das ausgewählt ist aus der Gruppe bestehend aus Kupfer, Silber, Gold, Nickel oder Aluminium oder deren Legierungen oder Kombinationen daraus.

7. Elektroelement gemäß einem der Ansprüche 1 - 6, wobei die Kontaktfläche in mindestens einer Dimension höchstens 20 % größer ist als die Höhe des Verbindungselements.

8. Elektroelement gemäß einem der Ansprüche 1 - 7, wobei die Kontaktfläche eine Legierung aufweist, insbesondere eine Silberlegierung und ganz besonders bevorzugt eine Silber-Platin-Legierung.

9. Verfahren zur Herstellung eines Verbindungselements, insbesondere nach einem der Ansprüche 1 - 8, auf einer Kontaktfläche aufweisend die Schritte:
a. Bereitstellen einer Litze, einer Kontaktfläche und eines Sintermittels,
b. Beschichten zumindest eines Teils der Litze mit Sintermittel unter Erhalt einer beschichteten Litze,
c. Positionieren der beschichteten Litze auf der Kontaktfläche,
d. Verbinden der beschichteten Litze mit der Kontaktfläche mittels Drucksintern unter Verwendung eines beheizten Stempels, unter Erzeugung eines Verbindungselements,
**dadurch gekennzeichnet, dass** der Stempel eine Vertiefung mit einer Öffnung aufweist wobei die Vertiefung im Stempel die beschichtete Litze beim Verbinden partiell aufnimmt und wobei die Öffnung der Vertiefung größer ist als der Durchmesser der beschichteten Litze, sodass die beschichtete Litze beim Drucksintern in die Vertiefung im Stempel auf die Kontaktfläche gepresst wird.

10. Verfahren gemäß Anspruch 9, wobei das Aspektverhältnis zwischen der Tiefe (t) der Vertiefung zu der Breite (w) der Öffnung der Vertiefung im Bereich von 0,5 bis 3 liegt.

11. Verfahren gemäß Anspruch 9 oder 10, wobei die Litze zumindest teilweise mit einer Isolierschicht umgeben ist.

12. Verfahren gemäß einem der Ansprüche 9 - 11, wobei das Beschichten der Litze mit Sintermittel durch Tränken, insbesondere durch eine Tauchbeschichtung erfolgt.

13. Verfahren gemäß einem der Ansprüche 9 - 12, wobei die Litze einen Querschnitt aufweist, dessen Aspektverhältnis im Bereich von 0,5 bis 2 liegt.

14. Verfahren gemäß einem der Ansprüche 9 - 13, wobei die Einzeldrähte der Litze verseilt oder verflochten sind.

15. Verfahren gemäß einem der Ansprüche 9 - 14, wobei die Litze zumindest teilweise mit Sintermittel getränkt wird, sodass die Einzeldrähte der Litze im Wesentlichen vollständig mit Sintermittel beschichtet werden.
